# EUROPÄISCHE PATENTSCHRIFT

(11) **EP 3 628 981 B1**
(45) Veröffentlichungstag und Bekanntmachung des Hinweises auf die Patenterteilung: **11.05.2022**
(21) Anmeldenummer: 19198845.0
(22) Anmeldetag: 23.09.2019
(51) Int. Cl.: G01D 11/24, G01K 1/08, H05K 1/02, H05K 1/14

(54) **SENSOREINRICHTUNG**
SENSOR DEVICE
DISPOSITIF DE DÉTECTION

(30) Priorität: 27.09.2018 DE 102018216663
(43) Veröffentlichungstag der Anmeldung: 01.04.2020
(73) Patentinhaber: Continental Automotive GmbH, 30165 Hannover (DE)
(72) Erfinder: Bartholomäus, Ulf, 78112 St. Georgen (DE)
(74) Vertreter: Continental Corporation

(56) Entgegenhaltungen:
- EP-A1- 3 355 032
- US-A1- 2013 014 578
- US-A1- 2015 334 864
- US-A1- 2017 251 913
- MARTINEZ-CATALA R V ET AL: "A Modular Wireless Sensor Platform With Fully Integrated Battery", IEEE TRANSACTIONS ON COMPONENTS AND PACKAGING TECHNOLOGIES,, Bd. 32, Nr. 3, 1. September 2009 (2009-09-01), Seiten 617-626, XP011346926, ISSN: 1521-3331, DOI: 10.1109/TCAPT.2009.2014875

## Beschreibung

Die Erfindung bezieht sich auf eine Sensoreinrichtung mit einem Sensorgehäuse, mit einem in und/oder an dem Sensorgehäuse angeordneten Sensorelement und mit einer mit dem Sensorelement elektrisch verbundenen, auf einer Leiterplatte angeordneten Messschaltung.

Es ist beispielsweise eine Sensoreinrichtung mit einem Sensorelemente aufweisenden Sensorrahmen zur Anbringung an einer Achse eines Landfahrzeugs bekannt. Die Sensorelemente der Sensoreinrichtung sind mittels einer Kabelverbindung mit einer entfernt von dem Sensorrahmen angeordneten Auswerte- und Steuerelektronik verbunden. Außerdem ist aus der US2013/014578 A1 eine Sensorvorrichtung mit einem Gehäuse bekannt, wobei in dem Gehäuse mehrere Sensorkomponenten und eine Leiterplatte angeordnet sind, wobei die Leiterplatte steife und flexible Bestandteile aufweist.

Aufgabe der Erfindung ist es, eine Sensoreinrichtung der eingangs genannten Art zu schaffen, die eine verbesserte Qualität von Sensorsignalen aufweist.

Diese Aufgabe wird erfindungsgemäß mit einer Sensoreinrichtung mit den Merkmalen des Anspruchs 1 gelöst.

Die erfindungsgemäße Sensoreinrichtung weist die besonderen Vorteile eines kompakten Aufbaus bei gleichzeitig Trennung potentiell störender Signale von der Messschaltung auf. Insbesondere kann die Sensoreinrichtung zur Befestigung an einer Fahrzeugachse eines Kraftfahrzeugs vorgesehen sein, das heißt die Sensoreinrichtung ist vorzugsweise derart ausgebildet, dass sie an einer Achse eines Kraftfahrzeugs befestigbar ist.

Das Sensorelement ist in und/oder an dem Sensorgehäuse angeordnet. Beispielsweise kann das Sensorelement an einer Innenseite des Sensorgehäuses angeordnet sein. Denkbar ist es zum Beispiel auch, dass das Sensorelement innerhalb des Sensorgehäuses und mit einem Abstand zu diesem angeordnet ist. Das Sensorgehäuse kann ein vollständig geschlossenes Gehäuse sein, es ist aber auch denkbar, dass das Sensorgehäuse Öffnungen oder Ausnehmungen aufweist. Beispielsweise kann das Sensorgehäuse topfförmig ausgebildet sein, und das Sensorelement und die Leiterplatte sind in dem Sensorgehäuse angeordnet, wobei zum Beispiel erst mit einer Anbringung der Sensoreinrichtung an einer Fahrzeugachse das Sensorgehäuse durch die Fahrzeugachse geschlossen oder zumindest teilgeschlossen wird.

Die Leiterplatte weist mehrere, vorzugsweise mindestens drei, weiter vorzugsweise genau drei, flexibel miteinander verbundene Leiterplattensegmente auf. Die flexible Verbindung der Leiterplattensegmente untereinander kann zum Beispiel jeweils eine biegsame und/oder gelenkige Verbindung sein. Das die Messschaltung tragende Leiterplattensegment ist in der Sensoreinrichtung in dem Sensorgehäuse derart angeordnet, dass einerseits das zweite Leiterplattensegment und andererseits das dritte Leiterplattensegment, von welchen Leiterplattensegmenten zumindest eines eine potentielle Störquelle für die Messschaltung trägt, zu dem die Messschaltung tragenden Leiterplattensegment benachbart ist.

Die Messschaltung ist vorzugsweise eine Analogeinheit. Insbesondere kann die Messschaltung zur Analogverarbeitung von elektrischen Signalen dienen. Beispielsweise kann die Messschaltung einen Analog-Digital-Converter (ADC) aufweisen. Als weiteres Beispiel kann die Messschaltung einen Analog-Digital-Converter mit Vorverstärker, auch als Analog-Front-End (AFE) bezeichnet, aufweisen.

Zusätzliche vorteilhafte Weiterbildungen der Erfindung sind in den Unteransprüchen angegeben.

Gemäß einer vorteilhaften Weiterbildung der Erfindung sind abgewinkelt zueinander angeordnete Leiterplattensegmente im abgewinkelten Zustand der Leiterplattensegmente unter einem rechten Winkel oder unter einem Winkel von 180°, das heißt parallel, zueinander angeordnet. Auf diese Weise kann ein vergleichsweise geringer Bauraum der Sensoreinrichtung erzielt werden, wobei gleichzeitig maximaler Platz zur Bestückung auf der Leiterplatte zur Verfügung steht.

Die Herstellung der Leiterplatte und damit auch der Sensoreinrichtung insgesamt kann vereinfacht werden, wenn gemäß einer anderen vorteilhaften Weiterbildung der Erfindung die Leiterplatte im nicht abgewinkelten Zustand der Leiterplattensegmente L-förmig ausgebildet ist und wenn das erste, die Messschaltung tragende Leiterplattensegment ein Ende eines Schenkels des L bildet. Der nicht abgewinkelte Zustand der Leiterplatte ist ein flächiger Zustand, das heißt alle Leiterplattensegmente sind in einer Ebene angeordnet.

Einer anderen vorteilhaften Weiterbildung der Erfindung gemäß bilden leiterplattendickenreduzierte Bereiche der Leiterplatte die flexiblen Verbindungen zwischen den Leiterplattensegmenten. Dadurch kann die Herstellung der Leiterplatte vereinfacht werden. Die leiterplattendickenreduzierten Bereiche der Leiterplatte können beispielsweise dadurch geschaffen werden, dass in diesen Bereichen die Leiterplatte ein- oder abgefräst ist, wodurch die Dicke der Leiterplatte in diesen ein- oder abgefrästen Bereichen jeweils verringert ist. Eine derart ausgebildete Leiterplatte hat den Vorteil, dass sie gefertigt und bestückt werden kann wie eine übliche insgesamt starre Leiterplatte. Ein weiterer Vorteil besteht darin, dass zum Beispiel keine Steckkontakte zwischen den einzelnen Leiterplattensegmenten zu deren Verbindung erforderlich sind.

Beispielsweise für eine gute Eignung der Sensoreinrichtung zur Verwendung in oder an einem Kraftfahrzeug weist die potentielle Störquelle oder weisen die potentiellen Störquellen gemäß einer vorteilhaften Weiterbildung der Erfindung eine zentrale Recheneinheit, auch bezeichnet als Central Processing Unit (CPU), und/oder eine Energieversorgung, auch bezeichnet als Power Supply, und/oder einen Controller-Netzwerk-Treiber, auch bezeichnet als Controller Area Network-Treiber (CAN-Treiber), auf. Gemäß einer anderen vorteilhaften Weiterbildung der Erfindung ist die Messschaltung dem Sensorelement, insbesondere direkt und unmittelbar, zugewandt auf der Leiterplatte angeordnet. Somit ist das erste Leiterplattensegment mit der Messschaltung gegenüber dem Sensorelement angeordnet. Mit der vorstehend beschriebenen Weiterbildung kann vorteilhaft unter anderem eine besonders geringe Länge von zum Beispiel elektrischen Verbindungsleitungen zwischen Messschaltung und Sensorelement erreicht werden.

Es ist zum Beispiel denkbar, dass die der Messschaltung abgewandte Rückseite des ersten Leiterplattensegments unbestückt und unbehandelt ist. Die der Messschaltung abgewandte Rückseite zumindest des ersten Leiterplattensegments weist jedoch gemäß einer anderen vorteilhaften Weiterbildung der Erfindung eine Schirmung auf. Die Schirmung, auch bezeichnet als Abschirmung, ist eine Schirmung zum Beispiel gegen (insbesondere die Messschaltung) störende elektrische Signale und/oder Felder und/oder Strahlungen. Die Schirmung kann vorzugsweise flächig ausgebildet sein.

mechanische Spannungen oder Dehnungen erfassende Sensorelemente ist es erfindungsgemäß vorteilhaft,

das Sensorelement an einem Sensorträger anzuordnen.

Der Sensorträger kann beispielsweise einer Membrane entsprechen. Zum Beispiel ist der Sensorträger ein metallischer Träger.

Eine besonders kompakte Bauform der Sensoreinrichtung kann erreicht werden, wenn gemäß einer vorteilhaften Weiterbildung der Erfindung der Sensorträger eine Außenwandung des Sensorgehäuses bildet oder Bestandteil einer Außenwandung des Sensorgehäuses ist.

Grundsätzlich kann das Sensorelement zum Erfassen einer beliebigen Größe ausgebildet sein. Beispielsweise ist es denkbar, dass das Sensorelement einen Temperaturfühler aufweist oder dass das Sensorelement ein Licht empfangendes Lichtaufnahmeelement aufweist. Hingegen weist gemäß einer vorteilhaften Weiterbildung der Erfindung das Sensorelement einen Dehnungsmessstreifen auf. Der Dehnungsmessstreifen kann beispielsweise an einem Sensorträger angeordnet sein, insbesondere kann der Dehnungsmessstreifen auf den Sensorträger aufgebracht sein. Der Sensorträger kann zum Beispiel blattfederartig ausgebildet sein und/oder gleichzeitig Bestandteil des Sensorgehäuses sein.

Gemäß einer anderen vorteilhaften Weiterbildung der Erfindung weist die Messschaltung einen Temperatursensor auf. Mithilfe des Temperatursensors kann vorteilhaft eine Verbesserung der Aussagekraft von mit der Sensoreinrichtung gewonnenen Messergebnissen erreicht werden. Der Temperatursensor dient insbesondere zur Linearisierung von Messwerten, zum Beispiel des Sensorelements.

Besonders vorteilhaft ist die Verwendung der beschriebenen Sensoreinrichtung zur Messung einer Achslast einer Fahrzeugachse eines Kraftfahrzeugs. Das Kraftfahrzeug kann insbesondere ein Nutzfahrzeug, vorzugsweise ein Lastkraftwagen, sein.

Ausführungsbeispiele der Erfindung werden im Folgenden anhand der Zeichnung näher beschrieben. In der Zeichnung zeigen in skizzenhafter, schematisierter Darstellung
- Figur 1: einen Ausschnitt einer Fahrzeugachse mit einer Sensoreinrichtung in einer Schnittansicht,
- Figur 2: den Ausschnitt der Fahrzeugachse mit der Sensoreinrichtung nach Figur 1 in einer Draufsicht und
- Figur 3: eine Leiterplatte der Sensoreinrichtung nach Figur 1.

Sich jeweils entsprechende Elemente sind in allen Figuren mit gleichen Bezugszeichen versehen.

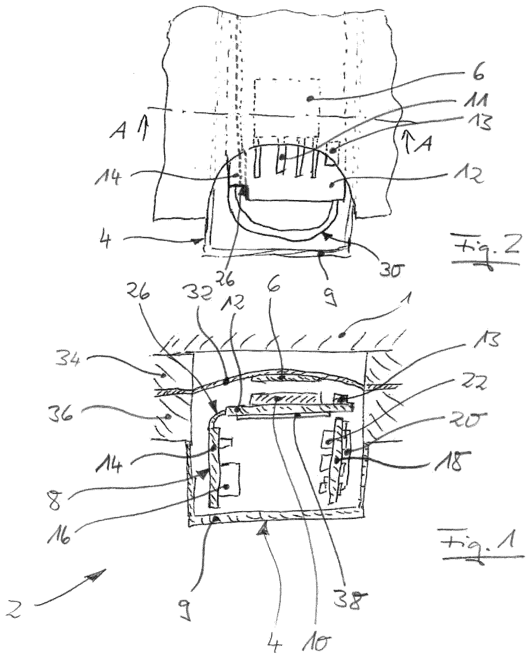

Figur 1 zeigt in einer (entlang Linie A - A in Figur 2) geschnittenen Ansicht eine an einer Fahrzeugachse 1 eines hier nicht weiter dargestellten Kraftfahrzeugs befestigte Sensoreinrichtung 2. Die Sensoreinrichtung 2 wird beispielsweise zur Messung einer Achslast der Fahrzeugachse 1 des Kraftfahrzeugs verwendet.

Die Sensoreinrichtung 2 weist ein Sensorgehäuse 4 und ein in dem Sensorgehäuse 4 angeordnetes Sensorelement 6 auf. Weiterhin ist in dem Sensorgehäuse 4 eine Leiterplatte 8 der Sensoreinrichtung 2 angeordnet. Eine Gehäusehaube 9 des Sensorgehäuses 4 kann zum Beispiel ein Kunststoffbauteil sein.

Das Sensorgehäuse kann vollständig geschlossen sein; im vorliegenden Ausführungsbeispiel ist das Sensorgehäuse 4 hingegen derart ausgebildet, dass es unter anderem die Leiterplatte 8 und das Sensorelement 6 schützend umfasst, diese aber nicht hermetisch zur Umgebung des Sensorgehäuses 4 abriegelt oder verschließt.

Auf der Leiterplatte 8 ist eine Messschaltung 10 angeordnet, die mit dem Sensorelement 6 mittels einer elektrischen Verbindungsleitung 11, die das Sensorelement 6 mit der Leiterplatte 8 elektrisch kontaktiert, elektrisch verbunden ist. Die innerhalb des Sensorgehäuses 4 angeordnete Leiterplatte 8 weist mehrere flexibel miteinander verbundene Leiterplattensegmente 12, 14, 18 auf.

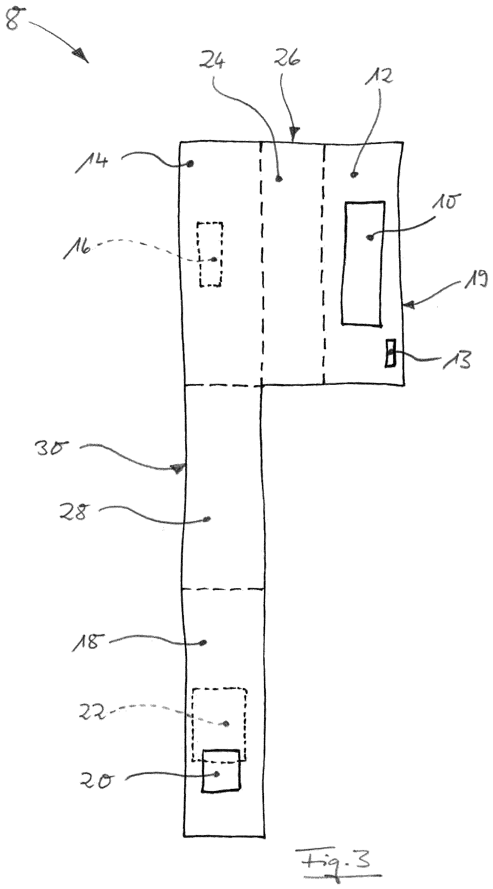

Zur Verdeutlichung ist in Figur 3 die Leiterplatte 8 in ebener, noch nicht in das Sensorgehäuse 4 eingefügter Anordnung gezeigt. In dieser ebenen Anordnung ist die Leiterplatte 8 L-förmig ausgebildet.

Die Leiterplatte 8 weist ein erstes Leiterplattensegment 12 auf, das die Messschaltung 10 trägt. Dieses Leiterplattensegment 12 bildet ein Ende eines Schenkels 19 des L.

Das erste Leiterplattensegment 12 trägt zudem einen Temperatursensor 13, den die Messschaltung 10 aufweist. Messschaltung 10 und Temperatursensor 13 können zum Beispiel in einem gemeinsamen Bauelementgehäuse zusammengefasst sein, oder sie können, wie in diesem Ausführungsbeispiel in Figuren 1 bis 3 gezeigt, unabhängig voneinander, bevorzugt nebeneinander, auf der Leiterplatte 8, vorzugsweise gemeinsam auf dem ersten Leiterplattensegment 12, angeordnet sein.

Ein zweites Leiterplattensegment 14, das innerhalb der Leiterplatte 8 benachbart zu dem ersten Leiterplattensegment 12 angeordnet ist, trägt eine potentielle Störquelle 16 für die Messschaltung 10. Ein drittes Leiterplattensegment 18, das innerhalb der Leiterplatte 8 benachbart zu dem zweiten Leiterplattensegment 14 angeordnet ist, trägt zwei potentielle Störquellen 20, 22 für die Messschaltung 10.

Die Leiterplattensegmente 12, 14, 18 sind flexibel miteinander verbunden. Dazu bildet ein erster leiterplattendickenreduzierter Bereich 24 der Leiterplatte 8 eine flexible Verbindung 26 zwischen dem ersten Leiterplattensegment 12 und dem zweiten Leiterplattensegment 14. Zudem bildet ein zweiter leiterplattendickenreduzierter Bereich 28 der Leiterplatte 8 eine flexible Verbindung 30 zwischen dem zweiten Leiterplattensegment 14 und dem dritten Leiterplattensegment 18.

In Figuren 1, 2 ist zu erkennen, dass die miteinander verbundenen, benachbarten Leiterplattensegmente 12, 14, 18 jeweils derart zueinander in dem Sensorgehäuse 4 angeordnet sind, dass im abgewinkelten Zustand der Leiterplattensegmente 12, 14, 18 das erste Leiterplattensegment 12, das die Messschaltung 10 trägt, zwischen dem zweiten Leiterplattensegment 14 und dem dritten Leiterplattensegment 18 angeordnet ist. Abgewinkelt zueinander angeordnete Leiterplattensegmente 12, 14, 18 sind im abgewinkelten Zustand der Leiterplattensegmente 12, 14, 18 unter einem rechten Winkel oder unter einem Winkel von 180° zueinander angeordnet, und zwar sind hier das erste Leiterplattensegment 12 und das zweite Leiterplattensegment 14 unter einem rechten Winkel zueinander angeordnet, und das zweite Leiterplattensegment 14 und das dritte Leiterplattensegment 18 sind unter einem Winkel von 180°, das heißt parallel, zueinander angeordnet. Außerdem sind hier auch das erste Leiterplattensegment 12 und das dritte Leiterplattensegment 18, die nicht miteinander verbunden sind, unter einem rechten Winkel zueinander angeordnet.

Das Sensorelement 6 ist an einem Sensorträger 32 angeordnet. Der Sensorträger 32 kann zum Beispiel ein metallischer Träger sein. Der Sensorträger kann beispielsweise eine metallische Membrane, insbesondere eine Messmembrane, sein. Das Sensorelement 6 weist beispielsweise einen hier nicht näher dargestellten Dehnungsmessstreifen auf.

In dem vorliegenden Ausführungsbeispiel ist der Sensorträger 32 zwischen einem ersten metallischen Halteträger 34 und einem zweiten metallischen Halteträger 36, die Bestandteil der Sensoreinrichtung 2 sind, eingespannt und gehalten. Der erste Halteträger 34 und der zweite Halteträger 36 sind gemeinsam mit dem Sensorgehäuse 4 und dem Sensorträger 32 an der Fahrzeugachse 1, zum Beispiel mittels hier nicht dargestellter Schrauben, befestigt. In dem hier gezeigten Ausführungsbeispiel sind Teile der Halteträger 34, 36 zugleich Bestandteil des Sensorgehäuses 4.

Die Messschaltung 10 ist dem Sensorelement 6 zugewandt auf der Leiterplatte 8, und zwar genauer auf dem ersten Leiterplattensegment 12 der Leiterplatte 8, angeordnet. Die der Messschaltung 10 abgewandte Rückseite zumindest des ersten Leiterplattensegments 12 weist in diesem Ausführungsbeispiel eine Schirmung 38 auf.

## Patentansprüche

1. Sensoreinrichtung (2) mit einem Sensorgehäuse (4), mit einem in und/oder an dem Sensorgehäuse (4) angeordneten Sensorelement (6) und mit einer mit dem Sensorelement (6) elektrisch verbundenen, auf einer Leiterplatte (8) angeordneten Messschaltung (10), wobei die Leiterplatte (8) innerhalb des Sensorgehäuses (4) angeordnet ist und mehrere flexibel miteinander verbundene Leiterplattensegmente (12, 14, 18) aufweist,
wobei benachbarte miteinander verbundene Leiterplattensegmente (12, 14, 18) jeweils derart zueinander abgewinkelt in dem Sensorgehäuse (4) angeordnet sind, dass im abgewinkelten Zustand der Leiterplattensegmente (12, 14, 18) ein erstes, die Messschaltung (10) tragendes Leiterplattensegment (12) zwischen einem zweiten Leiterplattensegment (14) und einem dritten Leiterplattensegment (18) angeordnet ist, wobei das zweite Leiterplattensegment (14) und/oder das dritte Leiterplattensegment (18) eine potentielle Störquelle (16, 20, 22) für die Messschaltung (10) tragen, **dadurch gekennzeichnet, dass** das Sensorelement (6) ein mechanische Spannungen oder Dehnungen erfassendes Sensorelement (6) ist und an einem Sensorträger (32) angeordnet ist, wobei die Messschaltung (10) mit dem Sensorelement (6) mittels einer elektrischen Verbindungsleitung (11), die das Sensorelement (6) mit der Leiterplatte (8) elektrisch kontaktiert, elektrisch verbunden ist.

2. Sensoreinrichtung nach Anspruch 1, **dadurch gekennzeichnet, dass** abgewinkelt zueinander angeordnete Leiterplattensegmente (12, 14, 18) im abgewinkelten Zustand der Leiterplattensegmente (12, 14, 18) unter einem rechten Winkel oder unter einem Winkel von 180° zueinander angeordnet sind.

3. Sensoreinrichtung nach Anspruch 1 oder 2, **dadurch gekennzeichnet, dass** die Leiterplatte (8) im nicht abgewinkelten Zustand der Leiterplattensegmente (12, 14, 18) L-förmig ausgebildet ist und dass das erste, die Messschaltung (10) tragende Leiterplattensegment (12) ein Ende eines Schenkels (19) des L bildet.

4. Sensoreinrichtung nach einem der vorhergehenden Ansprüche, **dadurch gekennzeichnet, dass** leiterplattendickenreduzierte Bereiche (24, 28) der Leiterplatte (8) die flexiblen Verbindungen (26, 30) zwischen den Leiterplattensegmenten (12, 14, 18) bilden.

5. Sensoreinrichtung nach einem der vorhergehenden Ansprüche, **dadurch gekennzeichnet, dass** die potentielle Störquelle oder potentiellen Störquellen (16, 20, 22) eine zentrale Recheneinheit und/oder eine Energieversorgung und/oder einen Controller-Netzwerk-Treiber aufweist beziehungsweise aufweisen.

6. Sensoreinrichtung nach einem der vorhergehenden Ansprüche, **dadurch gekennzeichnet, dass** die Messschaltung (10) dem Sensorelement (6) zugewandt auf der Leiterplatte (8) angeordnet ist.

7. Sensoreinrichtung nach einem der vorhergehenden Ansprüche, **dadurch gekennzeichnet, dass** die der Messschaltung (10) abgewandte Rückseite zumindest des ersten Leiterplattensegments (12) eine Schirmung (38) aufweist.

8. Sensoreinrichtung nach einem der vorhergehenden Ansprüche, **dadurch gekennzeichnet, dass** der Sensorträger (32) eine Außenwandung des Sensorgehäuses (4) bildet oder Bestandteil einer Außenwandung des Sensorgehäuses (4) ist.

9. Sensoreinrichtung nach einem der vorhergehenden Ansprüche, **dadurch gekennzeichnet, dass** das Sensorelement (6) einen Dehnungsmessstreifen aufweist.

10. Sensoreinrichtung nach einem der vorhergehenden Ansprüche, **dadurch gekennzeichnet, dass** die Messschaltung (10) einen Temperatursensor (13) aufweist.

11. Verwendung einer Sensoreinrichtung (2) nach einem der vorhergehenden Ansprüche zur Messung einer Achslast einer Fahrzeugachse (1) eines Kraftfahrzeugs.

## Claims

1. Sensor device (2) having a sensor housing (4), having a sensor element (6) arranged in and/or on the sensor housing (4) and having a measurement circuit (10), which is electrically connected to the sensor element (6) and arranged on a printed circuit board (8), wherein the printed circuit board (8) is arranged inside the sensor housing (4) and has a plurality of printed circuit board segments (12, 14, 18) which are flexibly connected to one another,
wherein adjacent printed circuit board segments (12, 14, 18) which are connected to one another are each arranged in the sensor housing (4) in a manner angled away from one another in such a way that, when the printed circuit board segments (12, 14, 18) are in the angled state, a first printed circuit board segment (12) which carries the measurement circuit (10) is arranged between a second printed circuit board segment (14) and a third printed circuit board segment (18), wherein the second printed circuit board segment (14) and/or the third printed circuit board segment (18) carry a potential interference source (16, 20, 22) for the measurement circuit (10), **characterized in that** the sensor element (6) is a sensor element (6) which detects mechanical stresses or strains and is arranged on a sensor carrier (32), wherein the measurement circuit (10) is electrically connected to the sensor element (6) by means of an electrical connecting line (11), which electrically contact-connects the sensor element (6) to the printed circuit board (8).

2. Sensor device according to Claim 1, **characterized in that** printed circuit board segments (12, 14, 18) which are arranged in a manner angled away from one another are arranged at a right angle or at an angle of 180° to one another when the printed circuit board segments (12, 14, 18) are in the angled state.

3. Sensor device according to Claim 1 or 2, **characterized in that** the printed circuit board (8) is formed in the shape of an L when the printed circuit board segments (12, 14, 18) are in the non-angled state and **in that** the first printed circuit board segment (12) which carries the measurement circuit (10) forms one end of a limb (19) of the L.

4. Sensor device according to one of the preceding claims, **characterized in that** regions (24, 28) of the printed circuit board (8) which have a reduced printed circuit board thickness form the flexible connections (26, 30) between the printed circuit board segments (12, 14, 18).

5. Sensor device according to one of the preceding claims, **characterized in that** the potential interference source or potential interference sources (16, 20, 22) has or have a central computation unit and/or an energy supply and/or a controller network driver.

6. Sensor device according to one of the preceding claims, **characterized in that** the measurement circuit (10) is arranged on the printed circuit board (8) so as to face the sensor element (6).

7. Sensor device according to one of the preceding claims, **characterized in that** the rear side at least of the first printed circuit board segment (12) which faces away from the measurement circuit (10) has a shielding (38).

8. Sensor device according to one of the preceding claims, **characterized in that** the sensor carrier (32) forms an external wall of the sensor housing (4) or is a component part of an external wall of the sensor housing (4).

9. Sensor device according to one of the preceding claims, **characterized in that** the sensor element (6) has a stress gauge.

10. Sensor device according to one of the preceding claims, **characterized in that** the measurement circuit (10) has a temperature sensor (13).

11. Use of a sensor device (2) according to one of the preceding claims for measuring an axle load of a vehicle axle (1) of a motor vehicle.

## Revendications

1. Dispositif de détection (2), comprenant un boîtier de capteur (4), un élément de détection (6) disposé dans et/ou sur le boîtier de capteur (4) et un circuit de mesure (10) disposé sur une carte de circuits imprimés (8) et relié électriquement à l'élément de détection (6), la carte de circuits imprimés (8) étant disposée à l'intérieur du boîtier de capteur (4) et présentant plusieurs segments de carte de circuits imprimés (12, 14, 18) reliés entre eux de manière flexible,
des segments de carte de circuits imprimés (12, 14, 18) voisins, reliés entre eux, étant disposés dans le boîtier de capteur (4) respectivement les uns par rapport aux autres de manière à former un angle de telle sorte qu'à l'état angulaire des segments de carte de circuits imprimés (12, 14, 18), un premier segment de carte de circuits imprimés (12) portant le circuit de mesure (10) est disposé entre un deuxième segment de carte de circuits imprimés (14) et un troisième segment de carte de circuits imprimés (18), le deuxième segment de carte de circuits imprimés (14) et/ou le troisième segment de carte de circuits imprimés (18) portant une source d'interférence potentielle (16, 20, 22) pour le circuit de mesure (10),
**caractérisé en ce que** l'élément de détection (6) est un élément de détection (6) détectant des contraintes ou allongements mécaniques qui est disposé sur un support de capteur (32), le circuit de mesure (10) étant relié électriquement à l'élément de détection (6) au moyen d'une ligne de raccordement électrique (11) qui met l'élément de détection (6) en contact électrique avec la carte de circuits imprimés (8).

2. Dispositif de détection selon la revendication 1, **caractérisé en ce que** des segments de carte de circuits imprimés (12, 14, 18) disposés les uns par rapport aux autres de manière à former un angle sont disposés les uns par rapport aux autres à l'état angulaire des segments de carte de circuits imprimés (12, 14, 18) selon un angle droit ou selon un angle de 180°.

3. Dispositif de détection selon la revendication 1 ou 2, **caractérisé en ce que** la carte de circuits imprimés (8) à l'état non angulaire des segments de carte de circuits imprimés (12, 14, 18) est réalisée en forme de L, et **en ce que** le premier segment de carte de circuits imprimés (12) portant le circuit de mesure (10) forme une extrémité d'une branche (19) du L.

4. Dispositif de détection selon l'une quelconque des revendications précédentes, **caractérisé en ce que** des zones (24, 28) à épaisseur de carte de circuits imprimés réduite de la carte de circuits imprimés (8) forment les raccordements flexibles (26, 30) entre les segments de carte de circuits imprimés (12, 14, 18).

5. Dispositif de détection selon l'une quelconque des revendications précédentes, **caractérisé en ce que** la source d'interférence potentielle ou les sources d'interférence potentielles (16, 20, 22) présente(nt) une unité de calcul centrale et/ou une alimentation en énergie et/ou un pilote de réseau de contrôleurs.

6. Dispositif de détection selon l'une quelconque des revendications précédentes, **caractérisé en ce que** le circuit de mesure (10) est disposé sur la carte de circuits imprimés (8) en étant tourné vers l'élément de détection (6).

7. Dispositif de détection selon l'une quelconque des revendications précédentes, **caractérisé en ce que** la face arrière, détournée du circuit de mesure (10), au moins du premier segment de carte de circuits imprimés (12) présente un blindage (38).

8. Dispositif de détection selon l'une quelconque des revendications précédentes, **caractérisé en ce que** le support de capteur (32) forme une paroi extérieure du boîtier de capteur (4) ou fait partie d'une paroi extérieure du boîtier de capteur (4).

9. Dispositif de détection selon l'une quelconque des revendications précédentes, **caractérisé en ce que** l'élément de détection (6) présente une jauge de contrainte.

10. Dispositif de détection selon l'une quelconque des revendications précédentes, **caractérisé en ce que** le circuit de mesure (10) présente un capteur de température (13).

11. Utilisation d'un dispositif de détection (2) selon l'une quelconque des revendications précédentes pour mesurer une charge à l'essieu d'un essieu de véhicule (1) d'un véhicule automobile.
